(19) Europäisches Patentamt
European Patent Office
Office européen des brevets

(11) **EP 1 420 416 B1**

(12) **FASCICULE DE BREVET EUROPÉEN**

(45) Date de publication et mention de la délivrance du brevet:
**13.08.2008 Bulletin 2008/33**

(51) Int Cl.:
**_G11C 17/18_** *(2006.01)* **_G11C 17/14_** *(2006.01)*

(21) Numéro de dépôt: **03300161.1**

(22) Date de dépôt: **16.10.2003**

(54) **Cellule mémoire à trois états**

Dreiphasenspeicherzelle

Three-state memory cell

(84) Etats contractants désignés:
**DE FR GB IT**

(30) Priorité: **30.10.2002 FR 0213615**

(43) Date de publication de la demande:
**19.05.2004 Bulletin 2004/21**

(73) Titulaire: **STMicroelectronics S.A.**
**92120 Montrouge (FR)**

(72) Inventeurs:
• **Wuidart, Sylvie**
**83910 Pourrieres (FR)**

• **Wuidart, Luc**
**83910 Pourrieres (FR)**

(74) Mandataire: **de Beaumont, Michel**
**1bis, rue Champollion**
**38000 Grenoble (FR)**

(56) Documents cités:
**EP-A- 0 511 560** **US-A- 4 146 902**
**US-A- 4 404 581**

EP 1 420 416 B1

## Description

La présente invention concerne le domaine des cellules mémoire réalisées en circuit intégré. Plus particulièrement, l'invention concerne la réalisation d'une cellule mémoire à partir de laquelle on puisse distinguer un état non programmé (issu de fabrication) de la cellule de deux états programmés et, plus généralement, distinguer le fait que la cellule mémoire ait été programmée dans un état quelconque après sa fabrication.
Une telle cellule mémoire est connue de EP-A-0 511 560. Aujourd'hui, pour remplir une telle fonction, on a généralement recours à des mémoires dites multi-niveaux associées à un compteur sur deux bits en éléments fusibles afin de verrouiller ou mémoriser une première programmation. L'interprétation des deux bits du compteur permet d'obtenir trois états pour la mémoire ainsi constituée.

La présente invention vise à proposer une cellule mémoire à trois états ou au moins à détection d'un état non programmé de la cellule, qui fournisse le résultat sur un bit unique.

L'invention vise, plus particulièrement, à éviter le recours à un compteur pour isoler les états respectifs de la cellule.

L'invention vise également à proposer une cellule à programmation irréversible.

L'invention vise en outre à proposer une cellule mémoire qui soit compatible avec un arrangement matriciel.

Pour atteindre ces objets et d'autres, la présente invention prévoit une cellule mémoire à au moins deux états détectables parmi lesquels un état non programmé, comprenant, en série entre deux bornes d'application d'une tension de lecture, au moins une première branche comportant :

> un étage de prélecture comprenant, en parallèle, deux résistances commutables ayant des valeurs différentes d'un premier écart prédéterminé ; et
> un étage de programmation constitué d'une résistance de programmation en silicium polycristallin, une borne de la résistance de programmation étant accessible par un circuit de programmation propre à provoquer une diminution irréversible de sa valeur.

Selon un mode de réalisation de la présente invention, ladite diminution de la valeur de la résistance de programmation est prédéterminée et choisie pour être supérieure audit premier écart entre les résistances de l'étage de prélecture.

Selon un mode de réalisation de la présente invention, la cellule comporte des commutateurs propres à appliquer une tension de programmation supérieure à la tension de lecture aux bornes de la résistance de programmation.

Selon un mode de réalisation de la présente invention, la cellule comporte au moins un interrupteur d'isolement de l'étage de prélecture par rapport à l'étage de programmation.

Selon un mode de réalisation de la présente invention, la lecture de l'état de la cellule est effectuée en deux étapes successives au cours desquelles lesdites résistances commutables de l'étage de prélecture sont sélectionnées alternativement.

Selon un mode de réalisation de la présente invention, ladite borne de la résistance de programmation constitue une borne de lecture de la cellule propre à être reliée à une première borne d'un amplificateur de lecture dont une deuxième borne reçoit au moins une tension de référence choisie pour être un niveau intermédiaire entre le niveau de tension pris par la borne de lecture dans les deux phases de lecture, alors que la résistance de programmation est dans un état non programmé.

Selon un mode de réalisation de la présente invention, la cellule comporte une deuxième branche de structure identique à la première, chaque résistance programmable étant connectée à la borne d'application de la tension de lecture opposée à l'étage de prélecture, par un transistor monté en bascule avec le transistor de l'autre branche.

Selon un mode de réalisation de la présente invention, les résistances commutables de la deuxième branche sont commandables en même temps que les résistances commutables de la première branche, de façon à ce que les valeurs respectives des résistances sélectionnées dans chacune des branches soient inversées.

Selon un mode de réalisation de la présente invention, la diminution irréversible de valeur susceptible d'être appliquée aux résistances de programmation est choisie pour être supérieure à la somme de l'écart entre les résistances de prélecture et d'un troisième écart de valeur nominale entre les résistances de programmation dans un état non programmé.

L'invention prévoit également un procédé de commande en lecture et en écriture d'une cellule mémoire à au moins deux états.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :

> la figure 1 représente un mode de réalisation d'une cellule mémoire selon la présente invention ;
> la figure 2 illustre, sous forme de chronogrammes, le fonctionnement d'une cellule mémoire telle que représentée en figure 1 ;
> la figure 3 représente un mode de réalisation d'un circuit logique de commande en programmation selon l'invention ;
> la figure 4 illustre, par une vue partielle en perspective, un mode de réalisation d'une résistance en silicium polycristallin constituant chacun des éléments de mémorisation de la cellule de la figure 1 ;

la figure 5 illustre, par un réseau de courbes, la programmation d'un élément de mémorisation tel qu'illustré par la figure 4 ; et

la figure 6 représente une variante de réalisation d'une cellule mémoire selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les circuits exploitant les états possibles d'une cellule mémoire selon l'invention ou d'un réseau de plusieurs cellules mémoire de ce type n'ont pas été détaillés. L'invention pourra être mise en oeuvre quelle que soit l'utilisation faite de l'état détecté.

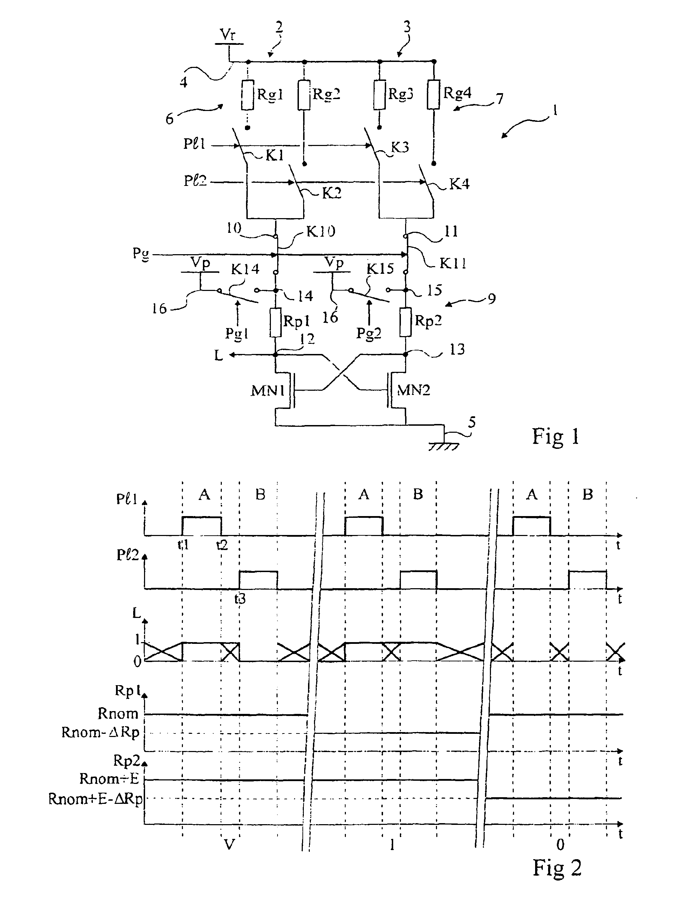

La figure 1 représente un premier mode de réalisation d'une cellule mémoire selon l'invention à au moins deux états détectables parmi lesquels un état non programmé.

Cette cellule 1 comporte deux branches parallèles 2, 3 identiques entre des bornes 4 et 5 d'application d'une tension d'alimentation Vr, la borne 5 représentant généralement la masse. Chaque branche 2, 3 comporte un étage 6, 7 de prélecture en série avec un étage respectivement 8, 9 de programmation. Chaque étage 6, 7 de prélecture comporte, en parallèle entre la borne 4 et l'étage de programmation 8 ou 9 correspondant (borne 10, respectivement 11) deux résistances commutables Rg1 et Rg2, respectivement Rg3 et Rg4. La commutation de ces résistances, c'est-à-dire l'introduction de chacune des résistances dans le circuit est assurée au moyen d'un interrupteur K1, K2, K3 ou K4, respectivement. Les interrupteurs K1 et K3 commutant les résistances Rg1 et Rg3 des branches 2 et 3 sont commandés ensemble au moyen d'un premier signal de prélecture P11. Les interrupteurs K2 et K4 d'introduction dans le circuit des résistances Rg2 et Rg4 sont commandés par un deuxième signal P12.

Selon l'invention, les résistances Rg1, Rg2, Rg3, Rg4 sont choisies pour avoir deux à deux des valeurs identiques avec une commande inversée. En d'autres termes, les valeurs des résistances Rg1 et Rg4 sont identiques, alors que les valeurs des résistances Rg2 et Rg3 sont identiques et supérieures d'une quantité prédéterminée ΔRg par rapport aux deux autres résistances.

Chaque étage de programmation 8, 9 comporte, en série entre l'étage de prélecture correspondant 6 ou 7 (bornes 10, 11), un commutateur K10, K11 d'isolement de l'étage de prélecture par rapport à l'étage de programmation, une résistance programmable Rp1, Rp2 et un transistor (par exemple, MOS à canal N) de confirmation de lecture MN1, MN2. Les grilles respectives des transistors MN1 et MN2 sont croisées c'est-à-dire que la grille du transistor MN1 de la branche 2 est connectée au point milieu 13 de l'association en série de la résistance Rp2 avec le transistor MN2 de la branche 3 tandis que la grille du transistor MN2 est connectée au point milieu 12 de la connexion en série de la résistance Rp1 avec le transistor MN1. Les points milieu 12 et 13 constituent les bornes de sortie, respectivement directe (état L) et inverse de la cellule 1.

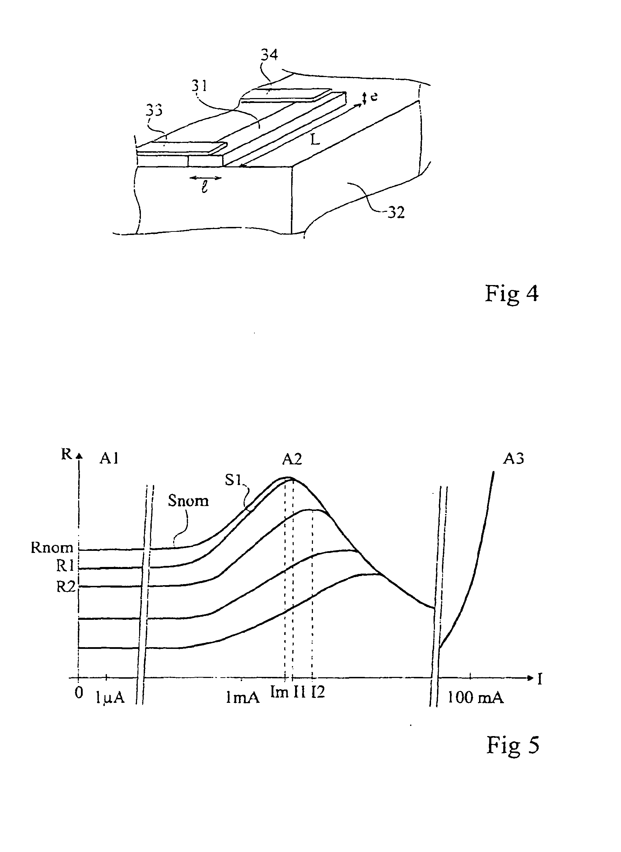

Selon l'invention, les résistances Rp1 et Rp2 sont des résistances en silicium polycristallin dont la valeur est programmable par diminution irréversible, comme cela sera exposé par la suite en relation avec les figures 4 et 5. Pour l'instant, on se contente de noter que si une des résistances Rp1 ou Rp2 en silicium polycristallin est soumise à un courant supérieur au courant pour lequel sa valeur est maximale, on assiste à une diminution irréversible de la valeur de sa résistance lorsque l'on revient à des courants situés dans la plage nominale de fonctionnement. La plage nominale de courants de fonctionnement d'une résistance en silicium polycristallin utilisée selon l'invention est inférieure à la centaine de microampères et, le plus souvent, inférieure à la dizaine de microampères. L'amplitude des courants de programmation est de l'ordre du milliampère. Un courant de programmation des résistances Rp1 et Rp2 tel qu'il soit supérieur au courant pour lequel la résistance correspondante présente une valeur maximale est obtenu en appliquant, entre les bornes 14 et 12, respectivement 15 et 13, de ces résistances, une tension Vp de programmation supérieure à la tension Vr d'alimentation normale de la cellule. En variante, la tension Vp est, comme cela est représenté en figure 1, appliquée entre les bornes 14, respectivement 15, et la masse 5 pourvu que les transistors de lecture MN1 et MN2 puissent supporter la tension correspondante. La sélection de celle des résistances Rp1 ou Rp2 soumise à un courant de programmation est effectuée au moyen d'interrupteurs (par exemple, des transistors MOS) K14, K15 reliant respectivement les bornes 14 et 15 des résistances Rp1 et Rp2 à une borne 16 d'application de la tension de programmation Vp.

Les interrupteurs K10 et K11 de programmation ont pour rôle essentiel d'isoler l'étage de prélecture d'une programmation de l'étage inférieur de la cellule de façon à protéger les résistances Rg1 à Rg4 et les interrupteurs K1 à K4 de l'application d'une tension qui pourrait s'avérer destructrice pour ces composants.

Selon une variante de réalisation, le rôle joué par les interrupteurs K10, K11 peut être rempli par les interrupteurs K1, K2, K3, K4 si ces derniers peuvent tenir la différence de tension entre la tension de programmation Vp et la tension de lecture Vr.

Selon l'invention, les résistances Rp1 et Rp2 sont choisies pour présenter des valeurs nominales différentes d'une quantité E. L'application de la tension de programmation Vp à l'une des deux résistances est alors choisie pour provoquer une différence de valeur entre la résistance programmée et l'autre résistance restant à sa valeur nominale, d'une quantité ΔRp, supérieure à la quantité E.

Selon la présente invention, les relations entre les valeurs des différentes résistances et leurs écarts respectifs sont choisies de la façon suivante :

- l'écart ΔRg entre les résistances de prélecture Rg1 de valeur Rg et Rg3, respectivement Rg4 de valeur Rg et Rg2, est choisi pour être supérieur au déséquilibre initial (natif) E entre les résistances de programmation Rp1 et Rp2, en s'assurant que cette relation soit respectée quelles que soient les dispersions de fabrication entre les résistances ; et

- la quantité ΔRp de différenciation des résistances programmables Rp1 et Rp2 est choisie pour être supérieure à la somme de l'écart ΔRg entre les résistances de prélecture et de l'écart natif E entre les résistances de programmation Rp1 et Rp2.

De préférence, l'écart E est choisi pour être le plus faible possible en restant compatible avec les dispersions technologiques de fabrication. En d'autres termes, cet écart E correspond approximativement aux dispersions technologiques maximales de fabrication possibles dans l'ensemble des résistances, y compris celles des interrupteurs à l'état passant en série avec celles-ci.

La figure 2 illustre, par des chronogrammes représentant respectivement des exemples d'allures des signaux Pl1, Pl2 et L en fonctions des valeurs des résistances Rp1 et Rp2, le fonctionnement d'une cellule mémoire 1 telle qu'illustrée en figure 1. La figure 2 représente les trois états possibles de la cellule, à savoir : état non programmé ; programmation à l'état 1 ; et programmation à l'état 0.

Selon l'invention, une lecture de l'état de la cellule mémoire est effectuée en deux étapes.

En partie gauche de la figure 2, on suppose un état non programmé de la cellule. Dans une première étape (A), on active un des signaux P11 ou P12 (par exemple, le signal P11 à un instant t1 où il ferme les interrupteurs K1 et K3). S'agissant d'une lecture, on suppose que les interrupteurs K10 et K11 sont fermés tandis que les interrupteurs K14 et K15 sont ouverts, de même que les interrupteurs K2 et K4, le signal P12 et les signaux Pg1 et Pg2 étant à l'état inactif. Comme la résistance Rg3 est égale à Rg + ΔRg, et que les résistances Rp1 et Rp2 sont dans leurs états issus de fabrication (c'est-à-dire non programmés et présentant des valeurs respectives Rnom et Rnom + E), la résistance totale de la branche 2 est égale à Rg + Rnom alors que la résistance totale de la branche 3 est égale à Rg + ΔRg + Rnom + E. Il en découle un déséquilibre entre les potentiels des noeuds 12 et 13, le potentiel du noeud 12 étant supérieur à celui du noeud 13. Il s'ensuit une conduction plus rapide du transistor MN2, ce qui stabilise l'état ainsi détecté en ouvrant le transistor MN1. Dans cet exemple, l'état L est alors un état haut (1). Cet état haut, noté 1 par convention, est mémorisé, par exemple dans un registre temporaire (non représenté) associé à la mémoire ou au circuit d'exploitation des résultats de lecture. La première étape A de lecture se termine à un instant t2 par l'ouverture des commutateurs K1 et K3. A un instant t3, légèrement postérieur pour éviter une conduction simultanée dans les deux résistances de chaque branche, on active le signal P12 pour fermer les commutateurs K2 et K4. L'ouverture des interrupteurs K1 et K3 entre les instants t2 et t3 a rendu l'état L (noeud 12) de sortie flottant (illustré par une croix en figure 2). A l'instant t3, la mise en conduction des interrupteurs K2 et K4 conduit à ce que la résistance globale de la branche 2 est Rg + ΔRg + Rnom alors que la résistance globale de la branche 3 est Rg + Rnom + E. Comme les résistances Rg1 à Rg4 sont dimensionnées pour que la quantité ΔRg soit supérieure à E, la résistance de la branche 2 est désormais supérieure à celle de la branche 3. Il en découle un déséquilibre inversé de la cellule mémoire dans la deuxième étape B de lecture, le potentiel du point 12 étant inférieur à celui du point 13. Cet état bas (noté 0 par convention) en sortie se retrouve comme précédemment stabilisé par les transistors MN1 et MN2.

On constate donc que, si avec deux lectures successives de la cellule en inversant les signaux P11 et P12, on obtient deux états successifs différents sur la même borne 12, cela signifie que la cellule 1 est vierge, c'est-à-dire dans un état non programmé tel qu'issu de fabrication.

Supposons désormais que l'une des résistances Rp1 ou Rp2 (par exemple, la résistance Rp1) a été programmée par diminution irréversible de sa valeur (portion centrale de la figure 2). Une telle programmation est, selon l'invention, prévue pour diminuer la valeur de la quantité ΔRp.

En reproduisant un cycle de lecture constitué des deux étapes A et B, on commence par fermer les interrupteurs K1 et K3. La résistance totale de la branche 2 est Rg + Rnom - ΔRp. La résistance de la branche 3 est Rg + ΔRg + Rnom + E. Le déséquilibre des résistances entre les deux branches (supérieure dans la branche 3) conduit à un état haut sur le noeud 12, comme précédemment confirmé par les transistors MN1 et MN2. Dans la deuxième étape B de lecture (fermeture des interrupteurs K2 et K4), la résistance globale de la branche 2 est Rg + ΔRg + Rnom - ΔRp. La résistance de la branche 3 est Rg + Rnom + E. Comme ΔRp est supérieure à ΔRg, la résistance de la branche 3 reste supérieure à la résistance de la branche 2. Par conséquent, on assiste encore à un état haut sur le noeud 12. On est donc en présence d'un état programmé 1 qui se différencie bien de l'état vierge V décrit précédemment.

Supposons maintenant une programmation par diminution irréversible de sa valeur de la résistance Rp2 d'une quantité ΔRp, la résistance Rp1 restant à la valeur nominale Rnom (partie droite de la figure 2).

Dans la première étape A de lecture, la résistance globale de la branche 2 est Rg + Rnom alors que la résistance globale de la branche 3 est Rg + ΔRg + Rnom + E - ΔRp. Comme ΔRp est choisie pour être supérieure à la somme ΔRg + E, la résistance de la branche 3 est inférieure à la résistance de la branche 2. Il en découle un état L bas sur la borne 12 pendant la première étape de lecture. Dans la deuxième étape B de lecture, la résistance globale de la branche 2 est Rg + ΔRg + Rnom alors que la résistance de la branche 3 est Rg + Rnom + E - ΔRp. Comme ΔRp est supérieure à E, la résistance de la branche 3 est là encore inférieure à la résistance de la branche 2. On retrouve donc, dans la deuxième étape de lecture, encore un état L bas sur la borne 12. Cet état bas correspond à un état 0 programmé de la cellule mémoire.

De ce qui précède, on voit bien que le seul cas où l'état de la borne de lecture de la cellule mémoire est différent dans les deux étapes de lecture est le cas où la cellule est vierge, c'est-à-dire n'a jamais été programmée.

Dans la description qui précède, on a pas tenu compte des résistances série dans les interrupteurs à l'état passant dans la mesure où ces résistances ont des contributions identiques sur les deux branches (aux dispersions technologiques près, dont on peut tenir compte dans la détermination de la quantité E).

On notera que la cellule mémoire 1 de la figure 1 pourrait être reprogrammée un nombre limité de fois après une première programmation. En effet, on pourrait provoquer une diminution de la valeur de celle des deux résistances Rp1 et Rp2 qui n'a pas été programmée lors d'une première programmation pour, soit revenir vers l'état vierge, soit programmer la cellule dans un état inverse.

Toutefois, selon un mode de réalisation préféré de la présente invention, appliqué notamment à des applications dites sécuritaires, on souhaite garantir que la cellule ne puisse être reprogrammée ni retrouver un état vierge après une première programmation. Pour cela, avant d'effectuer (d'autoriser) une programmation, il faut vérifier que la lecture de la sortie L indique bien que la cellule est vierge.

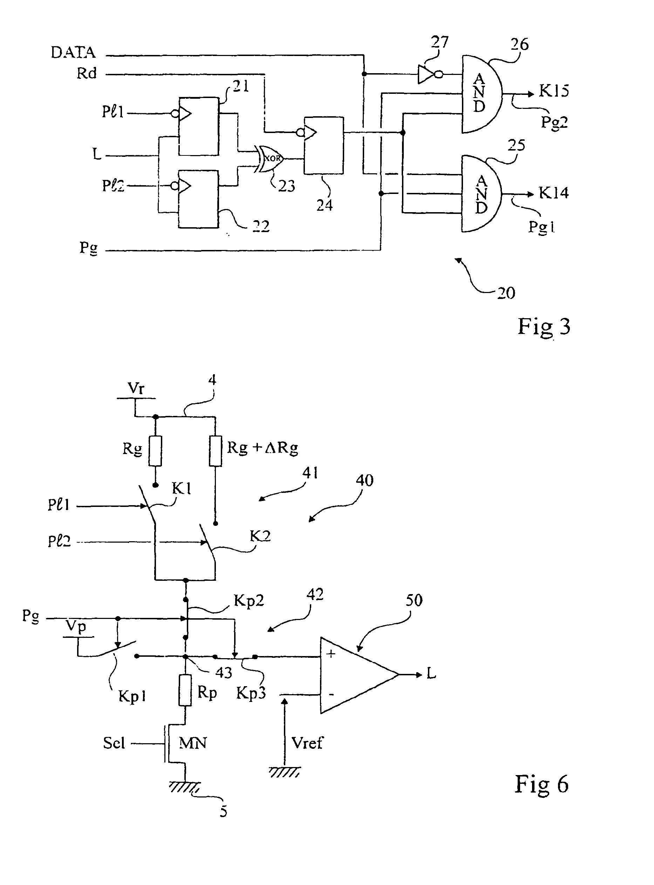

La figure 3 représente un mode de réalisation d'un circuit 20 de commande en programmation permettant d'atteindre cet objectif. En figure 3, la cellule 1 n'a pas été représentée. En fait, le circuit de la figure 3 permet de générer les signaux Pg1 et Pg2 de commande des interrupteurs K14 et K15, lors d'une commande en programmation d'un état DATA, identifiée par un état haut sur le signal Pg.

Le circuit 20 comporte deux bascules 21 et 22 recevant respectivement sur leurs entrées d'horloge les signaux P11 et P12 inversés et dont les entrées de donnée sont reliées au noeud 12 de sortie de la cellule fournissant le signal L. Les sorties directes des bascules 21 et 22 sont reliées aux entrées d'une porte 23 de type OU-Exclusif (XOR). La sortie de la porte 23 est reliée en entrée de données d'une bascule 24 dont l'entrée d'horloge reçoit l'inverse d'un signal Rd de commande en lecture, actif à l'état haut. La bascule 24 est donc déclenchée par le front descendant du signal Rd indiquant la fin d'un cycle de lecture. La sortie de la bascule 24 est reliée à des entrées de deux portes 25 et 26 de type ET (AND) à trois entrées dont les sorties respectives fournissent les signaux Pg1 et Pg2 à destination des interrupteurs K14 et K15. Les portes 25 et 26 reçoivent également le signal Pg de demande de programmation, ainsi que le signal DATA fournissant l'état du bit à programmer, le signal DATA traversant un inverseur 27 avant d'arriver sur la porte 26.

La programmation d'un état 0 ou 1 dans la cellule 1 par la fermeture d'un des interrupteurs K14 et K15 n'est autorisée par une des portes 25 et 26 que si la bascule 24 fournit un état haut. Or, un état haut en sortie de la bascule 24 ne peut intervenir que si, lors du front descendant du signal Rd indiquant la fin du cycle de lecture de la cellule 1, seule une des bascules 21 et 22 fournit un état haut. Comme les bascules 21 et 22 sont commandées par les inverses respectifs des signaux P11 et P12, elles lisent les états présents en sortie de la cellule 1 à l'issue des deux phases de lecture (A et B, figure 2). Par conséquent, c'est seulement si la cellule est vierge que la porte 23 fournira un état haut et autorisera une programmation à l'issue du cycle de lecture.

La réalisation d'un tel circuit en logique câblée permet de garantir une programmation unique et irréversible de la cellule 1.

En variante, le courant de programmation des résistances Rp1 et Rp2 est choisi de telle sorte que la valeur atteinte par une résistance programmée soit telle que l'autre résistance ne puisse prendre une valeur encore inférieure (par exemple, par application du même courant de contrainte).

Un avantage de l'invention est qu'elle permet d'enregistrer de façon irréversible une première programmation de la cellule mémoire après sa fabrication, en rendant cette programmation détectable par l'analyse d'un seul bit de sortie de la cellule.

Un autre avantage de l'invention est qu'elle permet de réaliser une cellule mémoire à trois états à programmation unique.

La figure 4 représente un mode de réalisation d'une résistance en silicium polycritallin constituant l'une des résistances Rp1 ou Rp2 de la cellule caractéristique de l'invention.

Une telle résistance (désignée par 31 en figure 4) est constituée d'une piste (dite aussi barreau) en silicium polycristallin obtenue par gravure d'une couche déposée sur un substrat 32 isolant. Le substrat 32 est indifféremment directement constitué du substrat du circuit intégré ou est constitué d'une couche isolante formant un substrat isolant ou équivalent pour la résistance 31. La résistance 31 est connectée, par ses deux extrémités, à des pistes conductrices (par exemple, métalliques) 33 et 34 destinées à raccorder le barreau résistif aux autres éléments du circuit intégré. La représentation schématique de la figure 4 ne fait pas référence aux différentes couches isolantes et conductrices constituant généralement le circuit intégré. Pour simplifier, on s'est contenté de représenter le barreau résistif 31 posé sur le substrat isolant 32 et en contact, par les extrémités de sa face supérieure, avec les deux pistes métalliques 33 et 34.

En pratique, les liaisons de l'élément résistif 31 aux autres composants du circuit intégré sont obtenues par des pistes plus larges en silicium polycristallin partant des extrémités du barreau 31 dans l'alignement de celui-ci. En d'autres termes, l'élément résistif 31 est généralement formé en rendant un tronçon d'une piste en silicium polycristallin plus étroit que le reste de la piste.

La résistance R de l'élément 31 est donnée par la formule suivante :

$$R = \rho(L/s),$$

où $\rho$ désigne la résistivité du matériau (silicium polycristallin le cas échéant dopé) constituant la piste dans laquelle est gravé l'élément 31, où L désigne la longueur de l'élément 31, et où s désigne sa section, c'est-à-dire sa largeur 1 par son épaisseur e. La résistivité $\rho$ de l'élément 31 dépend, entre autres, du dopage éventuel du silicium polycristallin le constituant.

Le plus souvent, lors de la réalisation d'un circuit intégré, on prévoit les résistances en faisant référence à une notion dite de résistance par carreau $R_\square$ (square résistance). Cette résistance par carreau se définit comme étant la résistivité du matériau divisée par l'épaisseur avec laquelle il est déposé. En reprenant la relation ci-dessus donnant la résistance d'un élément 31, la résistance est donc donnée par la relation :

$$R = R_\square * L/1.$$

Le quotient L/l correspond à ce que l'on appelle le nombre de carreaux (square number) constituant l'élément résistif 31. Cela représente, vu de dessus, le nombre de carreaux de dimension donnée en fonction de la technologie, mis côte à côte pour former l'élément 31.

La valeur de la résistance en silicium polycristallin est donc définie, à la fabrication, d'après les paramètres ci-dessus, conduisant à des résistivités et résistances dites nominales. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Une caractéristique de la présente invention est d'imposer temporairement, dans une résistance en silicium polycristallin (Rp) dont on souhaite diminuer irréversiblement la valeur, un courant de programmation ou de contrainte supérieur à un courant pour lequel la résistance passe par une valeur maximale, ce courant étant au-delà de la plage de courants de fonctionnement normal (en lecture) de cette résistance. En d'autres termes, on diminue la résistivité du silicium polycristallin dans la plage de courants de fonctionnement, de façon stable et irréversible, en imposant temporairement dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 5 illustre, par un réseau de courbes donnant la résistance d'un élément en silicium polycristallin du type de celui représenté en figure 4 en fonction du courant le traversant, un mode de mise en oeuvre de la présente invention pour programmer la résistance de la cellule mémoire.

On suppose que le silicium polycristallin ayant servi à la fabrication de l'élément résistif 31 (Rp) présente une résistivité nominale conférant à l'élément 31, pour les dimensions 1, L et e données, une valeur de résistance $R_{nom}$. Cette valeur nominale (d'origine) de la résistance correspond à la valeur prise de façon stable par l'élément résistif 31 dans la plage de courants de fonctionnement du système, c'est-à-dire généralement pour des courants inférieurs à 100 $\mu$A.

Selon l'invention, pour diminuer la valeur de la résistance et passer de façon irréversible et stable, par exemple, à une valeur R1 inférieure à $R_{nom}$, on applique aux bornes de l'élément résistif 31 un courant (par exemple I1), dit de contrainte, supérieur à un courant Im pour lequel la valeur de la résistance R de l'élément 31 est maximale sans toutefois être infinie. Comme l'illustre la figure 5, une fois que ce courant I1 a été appliqué à l'élément résistif 31, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 $\mu$A). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 5, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliquée pendant la phase de diminution irréversible. On notera en effet que la diminution irréversible opérée par l'invention s'effectue dans une phase spécifique de programmation, hors du fonctionnement normal en lecture (plage A1) du circuit intégré, c'est-à-dire hors du fonctionnement normal de la résistance.

Le cas échéant, une fois que la valeur de la résistance en silicium polycristallin a été abaissée vers une valeur inférieure (par exemple R1 en figure 5), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$.

On voit que toutes les allures de la résistance en fonction du courant se rejoignent sur la pente de décroissance de la valeur de la résistance, après être passé par le maximum de l'allure. Ainsi, pour un élément résistif donné ($\rho$, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint. En fait, le courant de contrainte provoque une élévation de température de l'élément en silicium, ce qui entraîne son fluage.

Bien sûr, on veillera à ne pas dépasser la plage de courants de programmation A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur I par rapport aux pistes d'accès plus larges pour être fortement conductrices. Dans le cas d'un accès aux extrémités du barreau par le dessus comme cela est illustré en figure 4, on réalisera des vias dans l'isolant surjacent (non représenté) du barreau de silicium polycristallin pour connecter des pistes métalliques 33 et 34 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes données. En d'autres termes, pour un élément de dimensions données, cela conditionne le point de départ de la valeur de la résistance, et par voie de conséquence, les valeurs de résistance obtenues pour des courants de contrainte données.

Pour passer de la valeur nominale à une valeur de résistance ou résistivité inférieure, on peut selon l'invention utiliser plusieurs méthodes.

Selon un premier mode de mise en oeuvre, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un deuxième mode de mise en oeuvre préféré, on prédétermine, par exemple par mesures, les différents courants à appliquer pour passer des différentes valeurs de résistance Rnom et Rnom + E aux valeurs inférieures Rnom - $\Delta$Rp et Rnom + E - $\Delta$Rp. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 5 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Les deux modes de mise de oeuvre ci-dessus peuvent être combinés. On peut ainsi, dans une première étape, sélectionner une valeur approximative (dans une table) et appliquer le courant prédéterminé correspondant. Puis, dans une deuxième étape, on affine la valeur de la résistance par des diminutions pas à pas de sa valeur.

Selon l'invention, la diminution irréversible de la résistance ou résistivité peut être effectuée après fabrication lorsque le circuit est dans son environnement fonctionnel. En d'autres termes, le circuit 4 de commande et les transistors de programmation décrits en relation avec les figures 1 et 2 peuvent être intégrés avec la ou les cellules mémoires.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux modes préférés de mise en oeuvre (prédéterminer des valeurs de contraintes en durée et en intensité, ou progression pas à pas jusqu'à la valeur souhaitée) sont parfaitement compatibles avec la prise en compte de la durée d'application de la contrainte.

A titre d'exemple particulier de mise en oeuvre, on a réalisé une résistance en silicium polycristallin dopée N+ ayant une section de 0,225 micromètre carré (l = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

La tension de programmation Vp peut être une tension variable selon que les niveaux de courant de programmation sont prédéterminés ou sont inconnus et doivent être obtenus par une augmentation par paliers.

Selon une variante de réalisation, le courant de programmation forcé dans la résistance Rp est fixé par la commande (tension de grille) du transistor de programmation correspondant, la tension Vp étant alors fixe.

Un avantage de la présente invention est qu'une cellule mémoire réalisée au moyen d'une résistance en silicium polycristallin programmable par diminution irréversible de sa valeur est compatible avec les technologies classiques de réalisation des transistors MOS. En particulier, aucun transistor à grille flottante n'est nécessaire pas plus que de structure tunnel comme pour la réalisation d'une mémoire EPROM.

Un autre avantage de l'invention est que le code stocké dans l'élément de mémorisation n'est pas détectable optiquement à la différence d'une résistance en silicium polycristallin utilisée comme fusible où la détérioration physique du barreau de silicium rend la programmation visible.

Un autre avantage de l'invention est que la modification irréversible de la valeur de la résistance programmée n'est pas destructrice et ne risque donc pas d'endommager d'autres parties du circuit. Cela permet notamment de prévoir une diminution de la valeur de la résistance après fabrication, et même au cours de sa vie dans son circuit applicatif.

Un autre avantage de la présente invention est qu'elle permet, dans un exemple d'application, de conserver un historique de la puce de circuit intégré sur des opérations que l'on souhaite surveiller et réaliser dans cette puce. En particulier, en provoquant la programmation d'une cellule mémoire telle qu'illustrée par la figure 1 suite à une certaine action, on peut distinguer le cas où l'action a été jugée positive ou négative par la programmation de la cellule du cas où cette action n'a jamais eu lieu depuis la fabrication de la cellule.

De préférence, les résistances Rg1 à Rg4 sont des résistances de précision de valeur fixe afin de pouvoir prévoir un $\Delta$Rg le plus faible possible tout en restant compatible avec les dispersions technologiques éventuelles.

La figure 6 représente un deuxième mode de réalisation d'une cellule mémoire 40 selon la présente invention. Ce mode de réalisation diffère essentiellement de celui de la figure 1 en ce sens qu'il est d'une structure non différentielle. On retrouve en figure 6 l'équivalent d'une seule des deux branches parallèles 2 et 3 de la figure 1, cette branche comporte un étage 41 de prélecture entre la borne 4 d'application de la tension de lecture Vr et un étage de programmation 42, l'étage de programmation 42 étant par ailleurs connecté à la masse 5. L'étage de prélecture 41 comporte deux branches parallèles contenant chacune la résistance Rg et une résistance Rg + ΔRg commutable par des commutateurs K1 et K2 associés en série et commandés respectivement par les signaux P11 et P12. Côté étage de programmation 42, on retrouve une résistance de programmation Rp en silicium polycristallin susceptible d'être isolée de l'étage de prélecture 41 par un interrupteur Kp2 commandé par un signal de programmation Pg. La programmation de la résistance Rp s'effectue par diminution irréversible de sa valeur en appliquant une tension Vp à ses bornes au moyen d'un interrupteur Kp1 reliant la tension Vp à la borne 43 de la résistance Rp connectée à l'interrupteur Kp2. Dans l'exemple de la figure 6, on a prévu un transistor MOS de sélection MN commandé par un signal Sel. Ce transistor est ici optionnel mais peut servir dans un agencement de plusieurs cellules mémoire 40 utilisant un même amplificateur de lecture 50. Un interrupteur Kp3, commandé par le signal Pg, est destiné à isoler l'amplificateur 50 de lecture de la résistance Rp lors de sa programmation, pour éviter de l'endommager si celui-ci ne supporte pas la tension Vp. Un tel interrupteur d'isolement peut également être prévu dans le mode de réalisation de la figure 1 décrit précédemment entre la borne 13 et les circuits d'interprétation de son état.

Selon le mode de réalisation de la figure 6, le point 43 est relié à une entrée (par exemple, non inverseuse) de l'amplificateur de lecture 50, l'entrée inverseuse de cet amplificateur différentiel recevant une tension de référence Vref. La sortie de l'amplificateur différentiel fournit l'état L lu dans la cellule 40.

Pour garantir une détection d'un état vierge issu de fabrication par rapport à un état programmé de la cellule 40, la tension de référence Vref appliquée sur l'amplificateur 50 doit être d'une valeur comprise entre Vr * Rnom / (Rg + ΔRg + Rnom) et Vr * Rnom / (Rg + Rnom). Avec un tel seuil, les états respectifs détectés par l'amplificateur 50 dans les deux étapes successives de lecture commandées par les signaux P11 et P12 conduisent à des états différents, respectivement 1 et 0, en sortie de l'amplificateur 50.

Par contre, si la résistance Rp est programmée par diminution irréversible de sa valeur jusqu'à un état Rnom - ΔRp et en supposant que la quantité ΔRp est choisie pour être supérieure à la quantité ΔRg, les valeurs respectives Vr* (Rnom-ΔRp) / (Rg+Rnom-ΔRp) et Vr* (Rnom-ΔRp) / (Rg+ΔRg+Rnom-ΔRp) présentes sur l'entrée non-inverseuse de l'amplificateur 50 dans les deux étapes de lecture seront inversées (respectivement 0 et 1) .

Dans le mode réalisation décrit ci-dessus, la mémoire ne possède qu'un état programmé. De plus, on notera que la programmation est irréversible, en ce sens qu'il n'est pas possible de retrouver l'état "vierge" en diminuant de nouveau la valeur de la résistance Rp.

Parmi les exemples possibles d'application de la présente invention, on citera la réalisation de témoins de cycles de vie d'un produit, de gestionnaires d'irréversibilité, de phases de vie d'une puce (durée de validité d'une carte bancaire, par exemple), de mémorisation d'alarmes majeures, etc.

Bien entendu, la présente invention est susceptible de diverses variantes et modifications qui apparaîtront à l'homme de l'art. En particulier, les dimensions données aux différentes résistances et les valeurs des tensions de lecture et de programmation sont à la portée de l'homme du métier à partir des indications fonctionnelles indiquées dans la présente description. Enfin, on notera que l'invention est aisément transposable d'une technologique à une autre.

**Revendications**

1. Cellule mémoire (1 ; 40) à au moins deux états détectables parmi lesquels un état non programmé, comprenant, en série entre deux bornes (4, 5) d'application d'une tension de lecture (Vr), au moins une première branche (2) comportant : un étage (9 ; 42) de programmation constitué d'une résistance de programmation en silicium polycristallin (Rp1, Rp2 ; Rp), une borne (14, 15 ; 43) de la résistance de programmation étant accessible par un circuit de programmation propre à provoquer une diminution irréversible (ΔRp) de sa valeur, **caractérisée en ce qu'**elle comporte en plus
un étage (6 ; 41) de prélecture comprenant, en parallèle, deux résistances commutables (Rg1, Rg2, Rg3, Rg4 ; Rg, Rg + ΔRg) ayant des valeurs différentes d'un premier écart (ΔRg) prédéterminé.

2. Cellule mémoire selon la revendication 1, **caractérisée en ce que** ladite diminution (ΔRp) de la valeur de la résistance de programmation (Rp1, Rp2 ; Rp) est prédéterminée et choisie pour être supérieure audit premier écart (ΔRg) entre les résistances (Rg1, Rg2, Rg3, Rg4 ; Rg, Rg + ΔRg) de l'étage de prélecture (6 ; 41).

3. Cellule mémoire selon la revendication 1 ou 2, **caractérisée en ce qu'**elle comporte des commutateurs (K14, K15 ; Kp1) propres à appliquer une tension (Vp) de programmation supérieure à la tension de lecture (Vr) aux bornes de la résistance de programmation (Rp1, Rp2 ; Rp).

4. Cellule mémoire selon l'une quelconque des revendications 1 à 3, **caractérisée en ce qu'**elle comporte au moins un interrupteur (K10, K11 ; Kp2) d'isolement de l'étage de prélecture (6 ; 41) par rapport à l'étage de programmation (9 ; 42).

**5.** Cellule mémoire selon l'une quelconque des revendications 1 à 4, **caractérisée en ce que** la lecture de l'état de la cellule est effectuée en deux étapes successives (A, B) au cours desquelles lesdites résistances commutables (Rg1, Rg2, Rg3, Rg4 ; Rg, Rg + ΔRg) de l'étage de prélecture (6 ; 41) sont sélectionnées alternativement.

**6.** Cellule mémoire selon la revendication 5, **caractérisée en ce que** ladite borne (43) de la résistance de programmation (Rp) constitue une borne de lecture de la cellule propre à être reliée à une première borne d'un amplificateur (50) de lecture dont une deuxième borne reçoit au moins une tension de référence (Vref) choisie pour être un niveau intermédiaire entre le niveau de tension pris par la borne de lecture (43) dans les deux phases de lecture (A, B), alors que la résistance de programmation est dans un état non programmé.

**7.** Cellule mémoire selon l'une quelconque des revendications 1 à 5, **caractérisée en ce qu'**elle comporte une deuxième branche (3) de structure identique à la première (2), chaque résistance programmable (Rp1, Rp2) étant connectée à la borne (5) d'application de la tension de lecture opposée à l'étage de prélecture (6), par un transistor (MN1, MN2) monté en bascule avec le transistor (MN2, MN1) de l'autre branche.

**8.** Cellule mémoire selon la revendication 7, **caractérisée en ce que** les résistances commutables (Rg3, Rg4) de la deuxième branche (3) sont commandables en même temps que les résistances commutables (Rg1, Rg2) de la première branche (2), de façon à ce que les valeurs respectives des résistances sélectionnées dans chacune des branches soient inversées.

**9.** Cellule mémoire selon la revendication 7 ou 8, **caractérisée en ce que** la diminution irréversible (ΔRp) de valeur susceptible d'être appliquée aux résistances de programmation (Rp1, Rp2) est choisie pour être supérieure à la somme de l'écart (ΔRg) entre les résistances de prélecture (Rg1, Rg2, Rg3, Rg4) et d'un troisième écart (E) de valeur nominale entre les résistances de programmation (Rp1, Rp2) dans un état non programmé.

**10.** Procédé de lecture d'une cellule mémoire conforme à l'une quelconque des revendications 1 à 9, **caractérisé en ce qu'**il consiste à effectuer deux étapes de lecture successives au cours desquelles lesdites résistances commutables de l'étage de prélecture sont respectivement sélectionnées.

## Claims

**1.** A memory cell (1; 40) with at least two detectable states among which is an unprogrammed state, comprising, in series between two terminals (4, 5) of application of a read voltage (Vr), at least one first branch (2) comprising:

a programming stage (9; 42) formed of a polysilicon programming resistor (Rp1, Rp2; Rp), a terminal (14, 15; 43) of the programming resistor being accessible by a programming circuit capable of causing an irreversible decrease (ΔRp) in its value, **characterized in that** it further comprises:
a pre-read stage (6; 41) comprising, in parallel, two switchable resistors (Rg1, Rg2, Rg3, Rg4; Rg, Rg + ΔRg) having different values with a first predetermined difference (ΔRg).

**2.** The memory cell of claim 1, **characterized in that** said decrease (ΔRp) in the programming resistance value (Rp1, Rp2; Rp) is predetermined and chosen to be greater than said first difference (ΔRg) between the resistances (Rg1, Rg2, Rg3, Rg4; Rg, Rg + ΔRg) of the pre-read stage (6; 41).

**3.** The memory cell of claim 1 or 2, **characterized in that** it comprises switches (K14, K15; Kp1) capable of applying a programming voltage (Vp) greater than the read voltage (Vr) across the programming resistor (Rp1, Rp2; Rp).

**4.** The memory cell of any of claims 1 to 3, **characterized in that** it comprises at least one switch (K10, K11; Kp2) for isolating the pre-read stage (6; 41) with respect to the programming stage (9; 42).

**5.** The memory cell of any of claims 1 to 4, **characterized in that** the reading of the cell state is performed in two successive steps (A, B) during which said switchable resistors (Rg1, Rg2, Rg3, Rg4; Rg, Rg + ΔRg) of the pre-read stage (6; 41) are alternately selected.

**6.** The memory cell of claim 5, **characterized in that** said terminal (43) of the programming resistor (Rp) forms a read terminal of the cell capable of being connected to a first terminal of a read amplifier (50) having a second terminal receiving at least one reference voltage (Vref) chosen to be an intermediary level between the voltage level taken by the read terminal (43) in the two read phases (A, B), while the programming resistor is in an unprogrammed state.

**7.** The memory cell of any of claims 1 to 5, **characterized in that** it comprises a second branch (3) having a structure identical to the first one (2), each programmable resistor (Rp1, Rp2) being connected to the terminal (5) of application of the read voltage opposite to the pre-read stage (6), by a transistor (MN1, MN2) assembled as a flip-flop with the transistor (MN2, MN1) of the other branch.

8. The memory cell of claim 7, **characterized in that** the switchable resistors (Rg3, Rg4) of the second branch (3) are controllable at the same time as the switchable resistors (Rg1, Rg2) of the first branch (2), so that the respective values of the resistors selected in each of the branches are inverted.

9. The memory cell of claim 7 or 8, **characterized in that** the irreversible value decrease ($\Delta$Rp) likely to be applied to the programming resistors (Rp1, Rp2) is chosen to be greater than the sum of the difference ($\Delta$Rg) between the pre-read resistances (Rg1, Rg2, Rg3, Rg4) and of a third nominal value difference (E) between the programming resistors (Rp1, Rp2) in an unprogrammed state.

10. A method for reading a memory cell according to any of claims 1 to 9, **characterized in that** it comprises performing two successive read steps during which said switchable resistors of the pre-read stage are respectively selected.

## Patentansprüche

1. Speicherzelle (1; 40) mit mindestens zwei detektierbaren Zuständen, unter denen ein nicht programmierter Zustand ist, welche in Reihe zwischen zwei Anschlüssen (4, 5) zum Anlegen einer Lesespannung (Vr) mindestens einen Zweig (2) aufweist, der Folgendes aufweist:

eine Programmierstufe (9; 42), die aus einem Programmierwiderstand (Rp1, Rp2; Rp) aus Polysilizium geformt ist, einen Anschluss (14, 15; 43) des Programmierwiderstandes, der durch eine Programmierschaltung zugänglich ist, die eine irreversible Verringerung ($\Delta$Rp) seines Wertes bewirken kann, **dadurch gekennzeichnet, dass** sie weiter Folgendes aufweist:
eine Vor-Lesestufe (6; 41) die parallel zwei schaltbare Widerstände (Rg1, Rg2, Rg3, Rg4; Rg, Rg + $\Delta$Rg) mit unterschiedlichen Werten mit einer ersten vorbestimmten Differenz ($\Delta$Rg) aufweist.

2. Speicherzelle nach Anspruch 1, **dadurch gekennzeichnet, dass** die Verringerung ($\Delta$Rp) des Programmierwiderstandswertes (Rp1, Rp2; Rp) vorbestimmt ist und so ausgewählt ist, dass sie größer als die erste Differenz ($\Delta$Rg) zwischen den Widerstän-

den (Rg1, Rg2, Rg3, Rg4; Rg, Rg + $\Delta$Rg) der Vor-Lesestufe (6; 41) ist.

3. Speicherzelle nach Anspruch 1 oder 2, **dadurch gekennzeichnet, dass** sie Schalter (K14, K15; Kp1) aufweist, die eine Programmierspannung (Vp) von mehr als der Lesespannung (Vr) an den Programmierwiderstand (Rp1, Rp2; Rp) anlegen können.

4. Speicherzelle nach einem der Ansprüche 1-3, **dadurch gekennzeichnet, dass** sie mindestens einen Schalter (K10, K11; Kp2) zum Isolieren der Vor-Lesestufe (6; 41) bezüglich der Programmierstufe (9; 42) aufweist.

5. Speicherzelle nach einem der Ansprüche 1-4, **dadurch gekennzeichnet, dass** das Lesen des Zellenzustandes in zwei aufeinander folgenden Schritten (A, B) ausgeführt wird, während denen die schaltbaren Widerstände (Rg1, Rg2, Rg3, Rg4; Rg, Rg + $\Delta$Rg) der Vor-Lesestufe (6; 41) abwechselnd ausgewählt werden.

6. Speicherzelle nach Anspruch 5, **dadurch gekennzeichnet, dass** der Anschluss (43) des Programmierwiderstandes (Rp) einen Leseanschluss der Zelle bildet, der mit einem ersten Anschluss eines Leseverstärkers (50) verbunden werden kann, der einen zweiten Anschluss hat, der mindestens eine Referenzspannung (Vref) aufnimmt, die so ausgewählt ist, dass sie auf einem Zwischenpegel zwischen dem Spannungspegel ist, der vom Leseanschluss (43) in den zwei Lesephasen (A, B) aufgenommen wird, während der Programmierwiderstand in einem unprogrammierten Zustand ist.

7. Speicherzelle nach einem der Ansprüche 1-5, **dadurch gekennzeichnet, dass** sie einen zweiten Zweig (3) mit einer Struktur aufweist, die identisch mit dem ersten Zweig (2) ist, wobei jeder programmierbare Widerstand (Rp1, Rp2) mit dem Anschluss (5) zum Anlegen der Lesespannung entgegengesetzt zur Vor-Lesestufe (6) verbunden ist, und zwar durch einen Transistor (MN1, MN2), der als Flip-Flop mit dem Transistor (MN2, MN1) des anderen Zweigs angeordnet ist.

8. Speicherzelle nach Anspruch 7 **dadurch gekennzeichnet, dass** die schaltbaren Widerstände (Rg3, Rg4) des zweiten Zweigs (3) zur gleichen Zeit steuerbar sind, wie die schaltbaren Widerstände (Rg1, Rg2) des ersten Zweigs (2), sodass die jeweiligen Werte der Widerstände, die in jedem der Zweige ausgewählt sind, umgekehrt sind.

9. Speicherzelle nach Anspruch 7 oder 8, **dadurch gekennzeichnet, dass** die irreversible Verringerung ($\Delta$Rp) des Wertes, die wahrscheinlich an die Programmierwiderstände (Rp1, Rp2) angelegt wird, so ausgewählt ist, dass sie größer als die Summe der Differenz ($\Delta$Rg) zwischen den Vor-Lesewiderständen (Rg1, Rg2, Rg3, Rg4) und einer dritten Nennwertdifferenz (E) zwischen den Programmierwiderständen (Rp1, Rp2) in einem nicht programmierten Zustand ist.

10. Verfahren zum Lesen einer Speicherzelle nach einem der Ansprüche 1 bis 9, **dadurch gekennzeichnet, dass** es aufweist, zwei aufeinander folgende Leseschritte auszuführen, während denen die schaltbaren Widerstände der Vor-Lesestufe jeweils ausgewählt werden.

Fig 1

Fig 2

Fig 3

Fig 6

Fig 4

Fig 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0511560 A